# EUROPÄISCHE PATENTANMELDUNG

(11) **EP 3 785 822 A1**
(43) Veröffentlichungstag der Anmeldung: **03.03.2021**
(21) Anmeldenummer: 20179243.9
(22) Anmeldetag: 10.06.2020
(51) Int. Cl.: B22D 7/06, B22D 25/06, B22D 27/00, B22D 27/04, F27B 14/10, F27B 14/08

(54) **VORRICHTUNG UND VERFAHREN ZUR HERSTELLUNG EINES GUSSSTÜCKES BEVORZUGT ALS VORMATERIAL**

(30) Priorität: 26.08.2019 AT 507352019
(71) Anmelder: LKR Leichtmetallkompetenzzentrum Ranshofen GmbH, 5282 Braunau am Inn- Ranshofen (AT)
(72) Erfinder: Reiter, Josef, 5142 Eggelsberg (AT); Birgmann, Alois, 5141 Moosdorf (AT); Gneiger, Stefan, 3351 Weistrach (AT); Kretz, Richard, 5280 Braunau am Inn (AT)
(74) Vertreter: Wirnsberger & Lerchbaum Patentanwälte OG

(57) **Zusammenfassung**

Die Erfindung betrifft eine Vorrichtung (1) zur Herstellung eines, insbesondere metallischen, Gussstückes, bevorzugt als Vormaterial, umfassend eine Temperierungsanlage, wobei die Vorrichtung (1) einen Tiegel (2) aufweist oder mit einem Tiegel (2) koppelbar ist, um im Tiegel (2) befindliches fließfähiges, insbesondere metallisches, Material in einem Einsatzzustand der Vorrichtung (1) zur Herstellung des Gussstückes durch Kühlung mit der Temperierungsanlage im Tiegel (2) erstarren zu lassen. Um eine hohe Güte bzw. Qualität des Gussstückes zu erreichen, ist erfindungsgemäß vorgesehen, dass mit der Temperierungsanlage eine Temperaturdifferenz zwischen einer ersten, insbesondere unteren, Region (A) und einer zweiten, insbesondere oberen, Region (B) des Tiegels (2) einstellbar ist, um zur gerichteten Erstarrung des Materials einen Temperaturgradienten im Material zu bewirken.

Weiter betrifft die Erfindung ein Verfahren zur Herstellung eines, insbesondere metallischen, Gussstückes, bevorzugt als Vormaterial.

## Beschreibung

Die Erfindung betrifft eine Vorrichtung zur Herstellung eines, insbesondere metallischen, Gussstückes, bevorzugt als Vormaterial, umfassend eine Temperierungsanlage, wobei die Vorrichtung einen Tiegel aufweist oder mit einem Tiegel koppelbar ist, um im Tiegel befindliches fließfähiges, insbesondere metallisches, Material in einem Einsatzzustand der Vorrichtung zur Herstellung des Gussstückes durch Kühlung mit der Temperierungsanlage im Tiegel erstarren zu lassen.

Des Weiteren betrifft die Erfindung ein Verfahren zur Herstellung eines, insbesondere metallischen, Gussstückes, bevorzugt als Vormaterial, wobei ein Tiegel, in welchem sich fließfähiges, insbesondere metallisches, Material befindet, mit einer Temperierungsanlage gekoppelt ist oder wird, wobei das Material zur Herstellung des Gussstückes durch Kühlung mit der Temperierungsanlage im Tiegel erstarren gelassen wird.

Zur Herstellung von Vormaterial, um dieses einer späteren Weiterverarbeitung häufig mit Umformungsverfahren, beispielsweise Strangpressen, Schmieden oder ECAP (Equal-Channel-Angular-Pressing), zuzuführen, ist es bekannt, metallische Materialien bzw. Legierungen in einem flüssigen Zustand zu mischen und als Schmelze in einem Tiegel in einen festen Zustand abzukühlen, um auf diese Weise ein Gussstück als Vormaterial in der Regel einfacher Geometrie entsprechend einer Form des Tiegels bzw. einer Kavität des Tiegels, in welcher die Schmelze abgekühlt bzw. erstarren gelassen wird, zu erhalten. Je nach Geometrie der Kavität des Tiegels wird auf diese Weise häufig Vormaterial in Form von Brammen, Blöcken oder Zylindern hergestellt.

Vormaterial kann damit zeiteffizient und mit wenig Aufwand hergestellt werden. Ist eine Weiterverarbeitung von Vormaterial im Rahmen von Umformprozessen vorgesehen, welche eine hohe Qualität in Bezug auf eine definierte Gefügestruktur und/oder eine möglichst homogene Zusammensetzung des Vormaterials erfordern, beispielsweise im Rahmen einer Weiterverarbeitung des Vormaterials zu medizintechnischen Produkten, wie etwa Implantaten, ist mit einer vorgenannten Herstellungsweise Vormaterial häufig nicht mit ausreichender Qualität herstellbar, um derartigen Ansprüchen ausreichend zu genügen.

Hier setzt die Erfindung an. Aufgabe der Erfindung ist es, eine Vorrichtung der eingangs genannten Art anzugeben, mit welcher ein, insbesondere metallisches, Gussstück bevorzugt als Vormaterial, mit hoher Güte bzw. Qualität herstellbar ist.

Weiter ist es ein Ziel, ein Verfahren der eingangs genannten Art anzugeben, mit welchem ein, insbesondere metallisches, Gussstück, bevorzugt als Vormaterial, mit hoher Güte bzw. Qualität hergestellt werden kann.

Die Aufgabe wird erfindungsgemäß durch eine Vorrichtung der eingangs genannten Art gelöst, wenn mit der Temperierungsanlage eine Temperaturdifferenz zwischen einer ersten, insbesondere unteren, Region und einer zweiten, insbesondere oberen, Region des Tiegels einstellbar ist, um zur gerichteten Erstarrung des Materials einen Temperaturgradienten im Material zu bewirken.

Grundlage der Erfindung ist die Idee, bei einer Herstellung von Vormaterial durch Abkühlung einer in einem Tiegel befindlichen Schmelze bzw. von Material in dessen Schmelzzustand Randbedingungen bei einem Erstarrungsvorgang der Schmelze derart vorzugeben bzw. zu kontrollieren, dass eine Erstarrung möglichst rasch und gleichzeitig mit einer sich ausbreitenden Erstarrungsfront mit möglichst vorgegebener Ausbreitungsrichtung erfolgt, um auf diese Weise eine definierte Gefügestruktur und homogene Zusammensetzung eines durch die Erstarrung der Schmelze im Tiegel hergestellten Gussstückes zu erhalten, und dadurch insbesondere eine Eignung des Gussstückes, bevorzugt als Vormaterial, für eine Weiterverarbeitung des Gussstückes zu hochqualitativen Produkten zu erreichen. Es wurde festgestellt, dass dies erreichbar ist, wenn einem Erstarrungsvorgang des fließfähigen bzw. flüssigen Materials im Tiegel als Randbedingung eine Temperaturdifferenz aufgeprägt wird, um dadurch eine, insbesondere steuerbare, gerichtete Erstarrung des im Tiegel befindlichen Materials zu erreichen. Vorteilhaft ist damit ein sukzessives Erstarren des im Tiegel befindlichen Materials in einer vorgegebenen Richtung bzw. ein kontrolliertes Fortschreiten einer Erstarrungsfront im erstarrenden Material erreichbar, wodurch eine Erstarrung rasch und mit homogener entstehender Gefügestruktur erzielbar ist, im Besonderen ohne dass dabei Lunker und/oder Porenverzweigungen im Gussstück entstehen.

Indem mit der Temperierungsanlage eine Temperaturdifferenz zwischen einer ersten Region des Tiegels und einer zweiten Region des Tiegels, insbesondere steuerbar, einstellbar ist, ist auf praktikable Weise ein Temperaturgradient in dem im Tiegel befindlichen Material erzeugbar, um eine gerichtete Erstarrung im Material zu erreichen bzw. zu steuern, da sich eine Erstarrung des Materials vorzugsweise in Richtung einer ansteigenden Temperatur im Material ausbreitet. Auf diese Weise können vorgenannte vorteilhafte Wirkungen auf praktikable Weise erreicht und insbesondere eine definierte Gefügestruktur und homogene Zusammensetzung des Gussstückes erzielt werden, sodass das Gussstück mit hoher Qualität bzw. Güte herstellbar ist. Zweckmäßig ist es, wenn die Temperierungsanlage ausgebildet ist, die erste Region und die zweite Region unterschiedlich stark zu kühlen bzw. insbesondere mit unterschiedlichen Kühlraten zu kühlen, also beispielsweise die erste Region mit einer größeren Kühlrate als die zweite Region zu kühlen oder umgekehrt, um einen Temperaturgradienten im Material zu bewirken, um eine gerichtete Erstarrung des Materials einzustellen und/oder zu steuern. Es versteht sich, dass eine Temperierung mit der Temperierungsanlage insbesondere derart erfolgt, dass die Temperaturdifferenz bzw. eine Kühlrate bzw. eine Kühlratendifferenz zwischen den Regionen abhängig von einer Solidus- und/oder Liquidustemperatur des Materials gewählt wird, um die gerichtete Erstarrung im Material zu erzeugen bzw. zu steuern.

Je nach konkreter Einsatzsituation ist es günstig, wenn die Vorrichtung bzw. Temperierungsanlage derart ausgebildet ist, dass ein Tiegel mit dieser koppelbar, insbesondere in dieser anordenbar, ist oder ein Tiegel Teil der Vorrichtung bzw. Temperierungsanlage ist, um fließfähiges Material durch Kühlung mit der Temperierungsanlage im Tiegel erstarren zu lassen. So kann es praktikabel sein, wenn die Vorrichtung bzw. Temperierungsanlage mit unterschiedlichen Tiegeln, wobei die Tiegel bzw. deren Kavitäten insbesondere eine unterschiedliche Form bzw. Gestalt aufweisen, koppelbar ist bzw. ausgebildet ist, solche Tiegel aufzunehmen, üblicherweise abhängig davon, welche Form das herzustellende Gussstück aufweisen soll. Eine besonders robuste und/oder kompakte Ausgestaltung der Vorrichtung ist erreichbar, wenn der Tiegel als, insbesondere lösbarer oder nicht lösbarer, Teil der Vorrichtung bzw. der Temperierungsanlage ausgebildet ist. Je nach Anwendungssituation kann es günstig sein, wenn das Material in einer fließfähigen Form, insbesondere in einem flüssigen oder teilflüssigen Zustand, dem Tiegel zugeführt wird oder alternativ in fester Form dem Tiegel zugeführt und erst im Tiegel in einen fließfähigen, insbesondere flüssigen oder teilflüssigen, Zustand überführt wird.

Eine konkrete Ausgestaltung des Tiegels bzw. einer Kavität des Tiegels, in welcher Material anordenbar ist bzw. angeordnet wird, bemisst sich üblicherweise an einer zu erreichenden Form des Gussstückes und/oder einer Materialzusammensetzung, insbesondere Legierungszusammensetzung, des Materials und/oder thermophysikalischen Eigenschaften des Materials, wie einer Solidus- bzw. Liquidustemperatur, und/oder chemischen Eigenschaften, wie einer chemischen Reaktivität, des Materials, insbesondere in Bezug auf eine Umgebungsatmosphäre. So kann es günstig sein, wenn der Tiegel als offener oder geschlossener Tiegel ausgebildet ist. Abhängig von einer zu erreichenden Form des Gussstückes kann es praktikabel sein, wenn der Tiegel als Kokille oder Gussform ausgebildet ist. Allerdings hat sich eine möglichst einfache Tiegelausgestaltung als bevorzugt herausgestellt, um eine gerichtete Erstarrung des Materials möglichst effizient zu erreichen. Es versteht sich, dass das Material üblicherweise in die Kavität des Tiegels, in der Regel über eine oder mehrere Befüllungsöffnungen des Tiegels, eingefüllt bzw. in dieser angeordnet wird, um durch Erstarrenlassen des Materials in der Kavität zur Herstellung des Gussstückes das Gussstück entsprechend einer Form der Kavität bzw. einer gussteilformenden Oberfläche der Kavität zu formen. Für eine einfache Handhabbarkeit zur Erzeugung des Temperaturgradienten im Material hat es sich als günstig erwiesen, wenn eine gussteilformende Oberfläche des Tiegels bzw. der Kavität des Tiegels zumindest abschnittsweise, bevorzugt gänzlich, im Wesentlichen eine Form einer Rotationsfläche aufweist, insbesondere zumindest abschnittsweise im Wesentlichen konusförmig, beispielsweise als Mantelfläche eines Zylinders, Kegels oder Kegelstumpfes, ausgebildet ist. Eine gerichtete Erstarrung ist besonders störungsresistent einstellbar, wenn eine gussteilformende Oberfläche des Tiegels bzw. der Kavität des Tiegels im Wesentlichen eine Form einer Mantelfläche eines Kegelstumpfes oder Pyramidenstumpfes aufweist. Insbesondere erleichtert eine derartig geformte Kavität ein Entnehmen des Gussstückes aus der Kavität nach einem Erstarren des Materials in dieser, wenn die Wände der gussteilformenden Oberfläche in Richtung einer Gussteilentnahmeöffnung bzw. Befüllungsöffnung des Tiegels divergent zueinander ausgebildet sind.

Ein Einsatzzustand, insbesondere der Vorrichtung bzw. der Temperierungsanlage bzw. des Tiegels, bezeichnet dabei, und im Speziellen in den nachstehenden Ausführungen, einen Arbeitszustand, in welchem der Tiegel zur Herstellung des Gussstückes mit der Vorrichtung bzw. Temperierungsanlage gekoppelt ist, oder ein Teil dieser ist, um durch Kühlung mit der Temperierungsanlage eine insbesondere gerichtete Erstarrung des Materials im Tiegel mit der Temperierungsanlage einzustellen bzw. zu steuern.

Es versteht sich, dass die Temperierungsanlage bevorzugt derart ausgebildet ist, dass im Einsatzzustand mit der Temperierungsanlage eine Temperaturdifferenz zwischen Regionen des Tiegels einstellbar bzw. erzeugbar ist, welche korrespondierend zu bzw. abgestimmt auf einer Länge des herzustellenden Gussstückes bzw. einer Länge, im Besonderen eines gussstückformenden Abschnittes, der Kavität des Tiegels voneinander beabstandet sind, um entlang einer Länge des Gussstückes, oder zumindest eines Teilstückes derselben, einen Temperaturgradienten, und insbesondere infolge eine gerichtete Erstarrung, im Material zu bewirken. Günstig ist es, wenn die Temperierungsanlage derart ausgebildet ist, dass im Einsatzzustand mit der Temperierungsanlage zu temperierende Regionen bzw. Regionen, zwischen welchen eine Temperaturdifferenz eingestellt werden soll, einstellbar wählbar sind; dies gilt im Besonderen für die erste Region und zweite Region des Tiegels. Dadurch kann eine Temperierung des Tiegels bzw. eine Steuerung einer Erstarrung des Materials abgestimmt auf eine Materialmenge im Tiegel erfolgen. Üblicherweise werden dabei Regionen des Tiegels in, insbesondere regelmäßigen, Abständen entlang einer Länge, meist Höhe, des Tiegels bzw. dessen Kavität für eine Temperierung bzw. für ein Einstellen einer Temperaturdifferenz zwischen diesen gewählt. Eine Region des Tiegels, insbesondere eine erste Region und/oder zweite Region und/oder dritte Region und/oder weitere Region des Tiegels, ist dabei vorzugsweise jeweils mit bzw. durch einen Abschnitt des Tiegels gebildet, welcher in einem, insbesondere horizontalen, Querschnitt des Tiegels die Kavität des Tiegels zumindest abschnittsweise, bevorzugt gänzlich, umfasst bzw. umhüllt.

Üblicherweise sind die Regionen des Tiegels, insbesondere die erste Region und zweite Region, zwischen welchen mit der Temperierungsanlage eine Temperaturdifferenz einstellbar ist bzw. eingestellt wird, beabstandet voneinander, insbesondere entlang einer Länge, meist entlang einer Höhe, des Tiegels, am Tiegel angeordnet. Von Vorteil ist es, wenn Regionen des Tiegels, insbesondere die erste Region und zweite Region, zwischen welchen mit der Temperierungsanlage eine Temperaturdifferenz einstellbar ist bzw. eingestellt wird, in unterschiedlichen Höhen in Bezug auf eine vertikale Achse am Tiegel angeordnet sind. Auf diese Weise ist ein Temperaturgradient mit einer vertikalen Richtungskomponente im Material bewirkbar, was sich als günstig in Bezug auf eine Nachspeisung von flüssigem Material für die Erstarrung bzw. den Erstarrungsvorgang gezeigt hat, ursächlich wohl weil die Nachspeisung des Materials von einem hydrostatischen Druck, insbesondere metallostatischen Druck, im Material gefördert wird. Eine besonders effiziente Nachspeisung ist dabei erreichbar, wenn eine gerichtete Erstarrung entgegen einer wirkenden Gravitationskraft erfolgt. Es hat sich entsprechend dabei bewährt, dass die in Bezug auf die vertikale Achse höher gelegene Region eine höhere Temperatur aufweist, insbesondere mit einer niedrigeren Kühlrate gekühlt bzw. beaufschlagt wird, als die Temperatur bzw. Kühlrate der in Bezug auf die vertikale Achse tiefer gelegene Region. Auf diese Weise kann insbesondere eine Bildung von Lunkern im Gussstück effizient gehemmt werden.

Eine effiziente Steuerung ist erreichbar, wenn die Vorrichtung zumindest eine Temperaturmesseinrichtung aufweist, um im Einsatzzustand eine Tiegeltemperatur und/oder eine Temperatur eines im Tiegel befindlichen Materials zu ermitteln, sodass die Temperierungsanlage in Abhängigkeit einer Ermittlungstemperatur der zumindest einen Temperaturmesseinrichtung steuerbar bzw. regelbar ist. Günstig ist es dabei, wenn die Vorrichtung mehrere Temperaturmesseinrichtungen aufweist, welche vorzugsweise in unterschiedlichen Regionen des Tiegels, insbesondere der ersten Region und zweiten Region des Tiegels, angeordnet sind. Dadurch ist die mit der Temperierungsanlage einstellbare Temperaturdifferenz besonders genau und insbesondere abgestimmt auf die Erstarrung bzw. den Erstarrungsvorgang steuerbar bzw. regelbar, wodurch eine besonders homogene Gefügestruktur erreichbar ist.

Bewährt hat es sich, dass die Temperierungsanlage eine oder mehrere, insbesondere separat voneinander steuerbare, Temperierungseinrichtungen, wie Kühleinrichtungen und/oder Heizeinrichtungen, aufweist, um im Einsatzzustand eine oder mehrere Temperaturdifferenzen zwischen mehreren Regionen des Tiegels, insbesondere eine Temperaturdifferenz zwischen der ersten Region und zweiten Region des Tiegels, zu erzeugen bzw. einzustellen, um zur gerichteten Erstarrung des Materials einen Temperaturgradienten im Material zu bewirken. Auf diese Weise können Temperaturdifferenzen zwischen den Regionen des Tiegels auf einfache Weise bewirkt bzw. eingestellt werden. Eine Temperierungseinrichtung kann dabei als Kühleinrichtung und/oder Heizeinrichtung ausgebildet bzw. betreibbar sein, sodass eine Temperaturdifferenz zwischen Regionen, insbesondere zwischen der ersten Region und zweiten Region, des Tiegels mit bzw. durch Variation einer Kühlleistung bzw. Heizleistung der Temperierungseinrichtung einstellbar ist. Hierbei ist es zum Erreichen einer gerichteten Erstarrung fallweise schon ausreichend, wenn die Temperierungsanlage eine einzige Temperierungseinrichtung, welche als Kühleinrichtung ausgebildet bzw. betreibbar ist, aufweist, um mit der Temperierungseinrichtung die erste oder zweite Region des Tiegels zu kühlen, sodass eine Temperaturdifferenz zwischen der ersten Region und zweiten Region des Tiegels bewirkt bzw. eingestellt wird. Wie vorstehend bereits ausgeführt, ist es hierbei günstig, wenn eine in Bezug auf eine vertikale Achse tiefer gelegene Region des Tiegels mit der Temperierungseinrichtung kühlbar ist bzw. gekühlt wird, sodass relativ zu einer in Bezug auf die vertikale Achse höher gelegenen Region eine Temperaturdifferenz einstellbar ist, um einen Temperaturgradienten im Material zu bewirken. Dies ist praktikabel umsetzbar, indem die Temperierungsanlage eine Kühleinrichtung aufweist, welche im Einsatzzustand an einem unteren Ende des Tiegels angeordnet ist, um eine untere Region des Tiegels zu kühlen, sodass eine Temperaturdifferenz in Bezug auf eine obere Region des Tiegels einstellbar ist, um einen Temperaturgradienten im Material zu bewirken. Um eine gerichtete Erstarrung effizient zu steuern, ist es jedoch vorteilhaft, wenn die Temperierungsanlage mehrere Temperierungseinrichtungen aufweist, wobei es in der Regel praktikabel ist, wenn unterschiedlichen Regionen des Tiegels unterschiedliche Temperierungseinrichtungen zugeordnet sind, um diese zu temperieren, insbesondere zu kühlen oder zu heizen, sodass eine Temperaturdifferenz zwischen diesen einstellbar ist bzw. eingestellt wird. Für eine effiziente Steuerung ist es zweckmäßig, wenn mehrere Temperierungseinrichtungen separat voneinander steuerbar sind, um die Temperaturdifferenz einzustellen.

Es versteht sich, dass die Temperierungsanlage in der Regel ausgebildet ist, insbesondere zumindest eine Temperierungseinrichtung aufweist, um im Einsatzzustand das im Tiegel befindliche Material zur Herstellung des Gussstückes zu kühlen, um das Material im Tiegel erstarren zu lassen.

Eine hohe Praktikabilität ist erreichbar, wenn die Temperierungsanlage derart ausgebildet ist, dass eine oder mehrere Temperierungseinrichtungen im Einsatzzustand relativ zum Tiegel, insbesondere entlang einer vertikalen Achse, verschiebbar sind, um unterschiedliche Abschnitte des Tiegels als Regionen des Tiegels für eine Temperierung mit der Temperierungseinrichtung auszuwählen bzw. festzulegen. Günstig ist es, wenn die Temperierungsanlage derart ausgebildet ist, dass ein Abstand zwischen mehreren Temperierungseinrichtungen relativ zueinander änderbar bzw. variierbar ist. Zweckmäßig ist es hierzu, wenn die Temperierungsanlage eine oder mehrere, insbesondere motorbetriebene, Verschiebeeinrichtungen aufweist, welche mit einer Temperierungseinrichtung oder mehreren Temperierungseinrichtungen verbunden sind, sodass im Einsatzzustand die eine Temperierungseinrichtung oder mehreren Temperierungseinrichtungen mit den Verschiebeeinrichtungen relativ zum Tiegel, insbesondere entlang einer vertikalen Achse, verschiebbar sind bzw. ein Abstand zwischen diesen relativ zueinander änderbar ist.

Die Temperierungseinrichtung kann als Kühleinrichtung und/oder Heizeinrichtung ausgebildet sein. Als Heizeinrichtung hat sich beispielsweise eine Ausbildung als elektrische Widerstandsheizung oder Peltier-Element-Heizung bewährt, welche insbesondere mit einer Anordnung von mehreren Heizelementen gebildet sein kann. Als Kühleinrichtung hat sich beispielsweise eine Ausbildung als Peltier-Element-Kühlung als praktikabel gezeigt, welche insbesondere mit einer Anordnung von mehreren Kühlelementen gebildet sein kann. Eine hohe Einsatzfähigkeit ist erreichbar, wenn die Temperierungseinrichtung als Heizeinrichtung und Kühleinrichtung ausgebildet bzw. betreibbar ist. Es versteht sich, dass es vorteilhaft sein kann, wenn unterschiedliche Temperierungseinrichtungen in Form von unterschiedlichen Heizeinrichtungen und/oder Kühleinrichtungen ausgebildet sind.

Günstig ist es, wenn eine oder mehrere der Temperierungseinrichtungen mit, insbesondere jeweils, zumindest einem Temperierungsmittelkreislauf, aufweisend ein, insbesondere flüssiges oder gasförmiges, Temperierungsmittel, bevorzugt ein Kühlmittel, gebildet sind, um im Einsatzzustand eine Region des Tiegels zu kühlen bzw. zu heizen. Auf diese Weise kann Wärme effizient vom Tiegel bzw. Material abgeführt bzw. diesem zugeführt werden. Der Temperierungsmittelkreislauf kann grundsätzlich entsprechend einem üblichen dem Fachmann bekannten Kühlmittelkreislauf zum Wärmetransport zu Heiz- und/oder Kühlzwecken ausgebildet sein. Auf diese Weise kann die Temperierungseinrichtung als Heizeinrichtung und/oder als Kühleinrichtung betrieben werden, je nach Anwendungssituation. Als Temperierungsmittel haben sich insbesondere übliche gasförmige und/oder flüssige Kühlmittel, wie Luft, Wasser, Öl oder Salzlösungen, bewährt. Eine effiziente Temperierung ist erreichbar, wenn der Temperierungsmittelkreislauf mit zumindest einem Temperierungsmittelrohr zur Führung von Temperierungsmittel ausgebildet ist, wobei das zumindest eine Temperierungsmittelrohr im Einsatzzustand zumindest abschnittsweise, insbesondere im Wesentlichen kreisförmig oder schraubenartig, üblicherweise den Tiegel, im Speziellen mittelbar oder unmittelbar, kontaktierend, um den Tiegel geführt ist, um den Tiegel bzw. eine Region des Tiegels zu heizen bzw. zu kühlen. Eine hohe Effizienz ist erreichbar, wenn der Temperierungsmittelkreislauf als Teil einer Wärmepumpe bzw. Kältemaschine ausgebildet ist bzw. mit einer solchen wärmeenergetisch bzw. für eine Wärmeübertragung gekoppelt ist. Eine hohe Energieeffizienz ist erreichbar, wenn Temperierungsmittelkreisläufe von unterschiedlichen Temperierungseinrichtungen mit zumindest einem Wärmetauscher, bevorzugt mehreren Wärmetauschern, für eine Wärmeübertragung zwischen den Temperierungsmittelkreisläufen miteinander gekoppelt sind. Hierfür ist es praktikabel, wenn ein Rücklauf eines Temperierungsmittelkreislaufes mit einem Vorlauf eines anderen Temperierungsmittelkreislaufes mit dem Wärmetauscher für eine Wärmeübertragung gekoppelt ist. Um eine große Temperierungsleistung, insbesondere Kühlleistung und/oder Heizleistung, zu erreichen, ist es günstig, wenn die Temperierungseinrichtung mit mehreren Temperierungsmittelkreisläufen gebildet ist.

Eine einfach zu handhabende Steuerung ist erreichbar, wenn die Temperierungsanlage eine erste Temperierungseinrichtung, welche bevorzugt als Kühleinrichtung ausgebildet bzw. betreibbar ist, aufweist, um im Einsatzzustand die erste Region des Tiegels auf eine erste Temperatur zu temperieren, bevorzugt zu kühlen, und eine zweite Temperierungseinrichtung, welche insbesondere als Kühleinrichtung und/oder Heizeinrichtung ausgebildet bzw. betreibbar ist, aufweist, um im Einsatzzustand die zweite Region des Tiegels auf eine zweite Temperatur zu temperieren, insbesondere zu kühlen bzw. zu heizen, welche höher ist als die erste Temperatur, um einen Temperaturgradienten im Material einzustellen. Zweckmäßig ist es dabei, wenn in Bezug auf eine vertikale Achse die erste Region des Tiegels tiefer als die zweite Region des Tiegels am Tiegel angeordnet ist. Auf einfache Weise ist dies üblicherweise umsetzbar, indem im Einsatzzustand die erste Temperierungseinrichtung an einem unteren Ende des Tiegels und die zweite Temperierungseinrichtung an einem oberen Ende des Tiegels anordenbar oder angeordnet ist bzw. wird. Um eine möglichst ausgedehnte gerichtete Erstarrung im Material zu erreichen, ist es zweckmäßig, wenn im Einsatzzustand die erste Region des Tiegels und die zweite Region des Tiegels etwa an gegenüberliegenden Enden der Kavität des Tiegels bzw. deren Befüllung mit Material am Tiegel anordenbar bzw. angeordnet sind bzw. entsprechend die Temperierungsanlage ausgebildet eine Temperaturdifferenz zwischen diesen einzustellen.

Eine besonders präzise Steuerung ist erreichbar, wenn die Temperierungsanlage zumindest eine dritte Temperierungseinrichtung bzw. eine oder mehrere weitere Temperierungseinrichtungen aufweist, um im Einsatzzustand zumindest eine zwischen der ersten Region und zweiten Region des Tiegels angeordnete dritte bzw. weitere Region des Tiegels zu temperieren, insbesondere zu kühlen und/oder zu heizen, um einen Temperaturgradienten im Material einzustellen. In der Regel ist die zumindest eine dritte Temperierungseinrichtung ausgebildet, im Einsatzzustand die dritte Region auf eine Temperatur zu temperieren, welche zwischen der Temperatur der ersten Region und der Temperatur der zweiten Region liegt. In analoger Weise können vorteilhaft weitere Temperierungseinrichtungen vorgesehen sein, um sukzessive weitere Temperaturdifferenzen zwischen weiteren Regionen des Tiegels einzustellen, um einen Temperaturgradienten im Material einzustellen.

Für eine einfache Handhabung und Steuerung hat es sich bewährt, wenn die erste Temperierungseinrichtung als Kühleinrichtung, die zweite Temperierungseinrichtung als Heizeinrichtung und gegebenenfalls die dritte Temperierungseinrichtung als Kühleinrichtung ausgebildet bzw. betreibbar ist bzw. betrieben wird.

Es versteht sich, dass es günstig ist, wenn mehrere, vorzugsweise sämtliche, Temperierungseinrichtungen in Bezug auf deren Temperierungsleistungen, insbesondere Heizleistungen und/oder Kühlleistungen, separat voneinander steuerbar sind.

Vorteilhaft ist es, wenn eine der Temperierungseinrichtungen, insbesondere die erste Temperierungseinrichtung, ausgebildet ist, im Einsatzzustand einen Boden bzw. eine Bodenfläche des Tiegels bzw. dessen Kavität zu temperieren, insbesondere zu kühlen, um einen Temperaturgradienten im Material einzustellen. Dies ist praktikabel umsetzbar, indem die Temperierungseinrichtung mit einem Temperierungsmittelkreislauf, insbesondere Kühlmittelkreislauf, gebildet ist, welcher zumindest ein Temperierungsmittelrohr zur Führung von Temperierungsmittel aufweist, welches Temperierungsmittelrohr zumindest abschnittsweise eine Standfläche korrespondierend zu einer Bodenfläche des Tiegels bzw. dessen Kavität bildend, beispielsweise mäanderartig oder spiralförmig, üblicherweise in einer Ebene, geführt ist. Auf diese Weise ist bei einer Kontaktierung der Temperierungsmitteleinrichtung bzw. deren Temperierungsmittelrohres mit der Bodenfläche des Tiegels bzw. dessen Kavität oder einer Anordnung des Temperierungsmittelrohres in der Nähe der Bodenfläche, um Wärme zwischen der Bodenfläche und der Temperierungsmitteleinrichtung zu übertragen, ein kurzer Wärmeübertragungsweg und damit eine effiziente Wärmeübertragung erreichbar.

Es hat sich bewährt, dass zumindest ein Wärmeleitkörper vorhanden ist, um im Einsatzzustand mit dem bzw. über den Wärmeleitkörper Wärme zwischen dem Tiegel und einer oder mehreren Temperierungseinrichtungen zu übertragen. Dies ist zweckmäßig umsetzbar, indem im Einsatzzustand der Wärmeleitkörper sowohl mit dem Tiegel als auch zumindest einer Temperierungseinrichtung zur Wärmeübertragung zwischen diesen in Kontakt steht bzw. eine solche Kontaktierung herstellbar ist. Für eine effiziente Wärmeübertragung ist es günstig, wenn eine oder mehrere Temperierungseinrichtungen zumindest teilweise, insbesondere gänzlich, innerhalb des Wärmeleitkörpers angeordnet ist, um Wärme zwischen der Temperierungseinrichtung und dem Wärmeleitkörper zu übertragen. Zweckmäßig ist es entsprechend, wenn der Wärmeleitkörper eine Außenfläche aufweist, welche korrespondierend zu einer Außenfläche des Tiegels geformt ist, an welcher der Wärmeleitkörper im Einsatzzustand angeordnet bzw. anordenbar ist, um Wärme zwischen dem Tiegel und dem Wärmeleitkörper zu übertragen. Günstig ist es, wenn der Wärmeleitkörper derart ausgebildet ist, dass dieser im Einsatzzustand einen Tiegelumfang zumindest teilweise, bevorzugt gänzlich, umfassend ausgebildet ist, beispielsweise indem der Wärmeleitkörper mit einer rohrförmigen oder ringartigen Gestalt bzw. einem Teilstück eines solchen ausgebildet ist. Praktikabel ist es, wenn mehreren Temperierungseinrichtungen jeweils ein eigener Wärmeleitkörper zugeordnet ist, um im Einsatzzustand Wärme, insbesondere entsprechend einer vorstehenden Ausführung, zwischen den Temperierungseinrichtungen und dem Tiegel über die Wärmeleitkörper zu übertragen. Insbesondere wenn eine Temperierungseinrichtung als Temperierungsmittelkreislauf ausgebildet ist, ist es günstig, wenn zumindest ein Abschnitt des Temperierungsmittelrohres des Temperierungsmittelkreislaufes zumindest teilweise, bevorzugt gänzlich, in einem Wärmeleitkörper geführt ist, um im Einsatzzustand Wärme zwischen Tiegel und Temperierungsmittelrohr zu übertragen, da auf diese Weise eine große Kontaktfläche zwischen Temperierungsmittelrohr und Tiegel erreichbar ist. Zweckmäßig ist es, wenn der Wärmeleitkörper bevorzugt mit einem Werkstoff mit hoher Wärmeleitfähigkeit gebildet ist, wie beispielsweise Kupfer oder Aluminium. Es versteht sich, dass unterschiedliche Wärmeleitkörper mit bzw. aus unterschiedlichen Werkstoffen gebildet sein können.

Eine hohe Robustheit ist erreichbar, wenn die Vorrichtung bzw. die Temperierungsanlage einen Tiegeltopf aufweist, in welchem der Tiegel bzw. zumindest ein Teil des Tiegels, üblicherweise ein unteres Ende des Tiegels, im Einsatzzustand, insbesondere unter Bildung einer formschlüssigen Verbindung, angeordnet oder für einen Einsatzzustand anordenbar ist. Eine effiziente Temperatursteuerung ist weiter erreichbar, wenn der Tiegeltopf mit einem mit einer Temperierungseinrichtung für eine Wärmeübertragung in Kontakt stehenden Wärmeleitkörper gebildet ist, welcher eine zu einer Außengestalt des Tiegels, insbesondere dessen unteren Endes, korrespondierende Tiegelaufnahme aufweist, sodass der Tiegel im bzw. für den Einsatzzustand in der Tiegelaufnahme angeordnet bzw. anordenbar ist, um über den Tiegeltopf Wärme zwischen dem Tiegel und der Temperierungseinrichtung zu übertragen. Die Temperierungseinrichtung kann entsprechend einer vorgenannten Ausführung einer Temperierungseinrichtung, insbesondere im Zusammenhang mit einem Wärmeleitkörper, ausgebildet sein. Bevorzugt ist die Temperierungseinrichtung zusätzlich oder alternativ entsprechend einer vorgenannten Temperierungseinrichtung zur Temperierung eines Bodens bzw. einer Bodenfläche des Tiegels ausgebildet. Vorteilhaft ist es entsprechend, wenn die Temperierungseinrichtung zumindest teilweise, insbesondere gänzlich, innerhalb der Tiegelaufnahme angeordnet ist bzw. im Falle einer Ausbildung der Temperierungseinrichtung mit einem Temperierungsmittelkreislauf zumindest ein Abschnitt des Temperierungsmittelrohres des Temperierungsmittelkreislaufes zumindest teilweise, insbesondere gänzlich, üblicherweise mäanderförmig oder spiralförmig geformt, innerhalb der Tiegelaufnahme angeordnet ist bzw. verläuft. Eine robuste Ausführung ist auf einfache Weise erreichbar, wenn der Tiegeltopf mit einem Metallblock als Wärmeleitkörper, insbesondere gebildet mit bzw. aus Kupfer oder Aluminium, ausgebildet ist. Für eine Temperierungsleistung bzw. Kühlleistung ist es günstig, wenn die Temperierungseinrichtung mit mehreren vorgenannten Temperierungsmittelkreisläufen gebildet ist.

Ungewollte Oxidationsreaktionen sind reduzierbar bzw. vermeidbar, wenn die Vorrichtung eine Schutzgaseinrichtung aufweist, um im Einsatzzustand den Tiegel bzw. ein im Tiegel befindliches Material mit Schutzgas, insbesondere Argon oder Helium, zu beaufschlagen. Dies ist praktikabel umsetzbar, indem die Schutzgaseinrichtung mit zumindest einem Schutzgaszuführungsrohr, insbesondere mit mehreren solcher, gebildet ist, über welches Schutzgas zum Tiegel bzw. in den Tiegel bzw. in eine Kavität des Tiegels zuführbar ist. Für eine gleichmäßige Verteilung des Schutzgases ist es zweckmäßig, wenn das Schutzgaszuführungsrohr mehrere, insbesondere eine Vielzahl von, Austrittsöffnungen aufweist, sodass im Einsatzzustand durch das Schutzgasrohr geleitetes Schutzgas durch die Austrittsöffnungen in Richtung Tiegel bzw. im Tiegel befindlichem Material austritt. Bewährt hat es sich hierfür, wenn das Schutzgaszuführungsrohr einen im Wesentlichen kreissektorförmig oder kreisförmig geformten Schutzgaszuführungsrohrabschnitt aufweist, in welchem solche Austrittsöffnungen angeordnet sind. Für eine einfache Handhabung ist es praktisch, wenn das Schutzgaszuführungsrohr zumindest abschnittsweise entlang eines Innenumfanges des Tiegels bzw. dessen Kavität oder eines Randes einer Befüllungsöffnung des Tiegels bzw. dessen Kavität geführt ist. Vor allem wenn der Tiegel als offener Tiegel ausgebildet ist, ist es günstig, wenn im Einsatzzustand ein, insbesondere vorstehend beschriebenes, Schutzgaszuführungsrohr an einem bzw. oberhalb eines offenen Ende(s) und/oder an einer bzw. oberhalb einer Befüllungsöffnung des Tiegels angeordnet ist, um das im Tiegel befindliche Material mit Schutzgas zu beaufschlagen.

Eine leichte Handhabbarkeit ist erreichbar, wenn der Tiegel lösbar, bevorzugt formschlüssig und/oder kraftschlüssig, mit einer Tiegelfixierungseinrichtung der Vorrichtung verbunden bzw. verbindbar ist. Insbesondere ist damit ein Lösen und/oder Verbinden des Tiegels mit der Vorrichtung bzw. einem Unterbau der Vorrichtung auf einfache Weise umsetzbar. Damit ist beispielsweise vorteilhaft ermöglicht, den Tiegel durch einen anderen Tiegel zu ersetzen, oder den Tiegel für eine Reinigung des Tiegels oder für ein Einfüllen von Material in den Tiegel von einem Unterbau bzw. Rest der Vorrichtung zu lösen und insbesondere anschließend wieder zu verbinden.

Ein kompakter Aufbau, im Besonderen wenn der Tiegel Teil der Vorrichtung ist bzw. ein nicht lösbarer Bestandteil dieser ist, ist erreichbar, indem zumindest eine, insbesondere mehrere, bevorzugt sämtliche, Temperierungseinrichtungen zumindest teilweise, bevorzugt gänzlich, in einer Tiegelwand oder mehreren Tiegelwänden des Tiegels bzw. einem den Tiegel bildenden Tiegelkörper angeordnet oder anordenbar sind. Dies gilt besonders im Einsatzzustand. Günstig ist es hierzu, wenn eine oder mehrere Tiegelwände zumindest abschnittsweise mit bzw. aus einem, insbesondere vorgenannten, Wärmeleitkörper gebildet sind, wodurch eine effiziente Wärmeübertragung zwischen im Tiegel befindlichem Material und der zumindest einen Temperierungseinrichtung erreichbar ist.

Von Vorteil ist es, wenn die Vorrichtung zumindest ein Isolierungselement aufweist, welches im Einsatzzustand an einer Außenfläche des Tiegels bzw. einer Region des Tiegels, beispielsweise der ersten Region oder zweiten Region des Tiegels, angeordnet bzw. anordenbar ist, um eine Wärmeabfuhr vom Tiegel bzw. einer Region des Tiegels an eine Umgebung zu hemmen. Dadurch kann eine ungesteuerte Wärmeabfuhr vom Tiegel bzw. einer Region des Tiegels an eine Umgebung reduziert werden, wodurch ein Einstellen der Temperaturdifferenz mit der Temperierungsanlage bzw. eine Steuerung der gerichteten Erstarrung präziser durchführbar ist. Bevorzugt weist die Vorrichtung mehrere solcher Isolierungselemente auf. Zweckmäßig ist es, wenn das Isolierungselement mit bzw. aus einem Werkstoff gebildet ist, welches eine geringere Wärmeleitfähigkeit als ein Werkstoff, mit bzw. aus welchem der Tiegel gebildet ist, aufweist. Beispielsweise kann das Isolierelement mit bzw. aus einer Keramik und/oder Schamotte gebildet sein. Eine effiziente Isolierung ist erreichbar, wenn das Isolierungselement eine Außenfläche aufweist, welche korrespondierend zu einer Außenfläche des Tiegels geformt ist, sodass das Isolierungselement im Einsatzzustand an der Außenfläche des Tiegels anordenbar bzw. angeordnet ist. Günstig ist es, wenn das Isolierungselement derart ausgebildet ist, dass dieses im Einsatzzustand einen Tiegelumfang zumindest teilweise, bevorzugt gänzlich, umfassend ausgebildet ist, beispielsweise indem das Isolierungselement mit einer im Wesentlichen rohrförmigen oder ringartigen Gestalt, oder einem Teilstück einer solchen, ausgebildet ist. Für eine präzise Steuerung hat es sich besonders bewährt, insbesondere bei einem offenen Tiegel, dass ein Isolierungselement an einer Befüllungsöffnung, bevorzugt einem Rand einer Befüllungsöffnung, des Tiegels angeordnet bzw. anordenbar ist. Bevorzugt ist das Isolierungselement dabei ausgebildet, ein einen Rand der Befüllungsöffnung bildendendes Segment des Tiegels zumindest teilweise, bevorzugt gänzlich, entlang eines Umfanges des Segmentes zu umfassen.

Es hat sich herausgestellt, dass die gerichtete Erstarrung besonders präzise steuerbar ist, wenn der Tiegel, insbesondere eine gussteilformende Oberfläche der Kavität des Tiegels, mit bzw. aus Graphit gebildet ist. Dies ist einfach umsetzbar, wenn ein den Tiegel bildender Tiegelkörper im Wesentlichen gänzlich mit bzw. aus Graphit gebildet ist. Praktikabel ist es kumulativ oder alternativ, wenn die gussteilformende Oberfläche der Kavität mit einer mit bzw. aus Graphit gebildeten Schicht ausgebildet ist, welche am Tiegelkörper angeordnet ist.

Das weitere Ziel der Erfindung wird bei einem Verfahren der eingangs genannten Art erreicht, wobei das Verfahren im Besonderen mit einer erfindungsgemäßen Vorrichtung durchführbar ist, wenn mit der Temperierungsanlage eine Temperaturdifferenz zwischen einer ersten, insbesondere unteren, Region und einer zweiten, insbesondere oberen, Region, des Tiegels eingestellt wird, um zur gerichteten Erstarrung des Materials einen Temperaturgradienten im Material zu bewirken. Wie vorstehend dargelegt, ist auf diese Weise als Folge des eingestellten Temperaturgradienten in dem im Tiegel befindlichen Material, eine gerichtete Erstarrung des Materials einstellbar bzw. steuerbar, sodass das Gussstück mit definierter Gefügestruktur und homogener Zusammensetzung herstellbar ist.

Es versteht sich, dass das erfindungsgemäße Verfahren entsprechend bzw. analog den Merkmalen, Vorteilen und Wirkungen, welche im Rahmen einer erfindungsgemäßen Vorrichtung zur Herstellung eines Gussstückes, insbesondere vorstehend, beschrieben sind, ausgebildet bzw. umgesetzt sein kann. Analoges gilt auch für die erfindungsgemäße Vorrichtung im Hinblick auf ein, insbesondere nachstehend beschriebenes, erfindungsgemäßes Verfahren zur Herstellung eines Gussstückes.

So hat es sich für eine einfache Steuerung bewährt, dass die Temperierungsanlage eine oder mehrere, insbesondere separat voneinander steuerbare, Temperierungseinrichtungen, wie Kühleinrichtungen und/oder Heizeinrichtungen, aufweist, mit welchen im Einsatzzustand eine oder mehrere Temperaturdifferenzen zwischen mehreren Regionen des Tiegels, insbesondere eine Temperaturdifferenz zwischen der ersten Region und zweiten Region des Tiegels, erzeugt bzw. eingestellt wird, um zur gerichteten Erstarrung des Materials einen Temperaturgradienten im Material zu bewirken.

Eine definierte Gefügestruktur bzw. homogene Zusammensetzung des Materials ist in besonders hohem Maße erreichbar, wenn das Material mit bzw. aus einer Magnesiumlegierung, insbesondere einer Magnesiumbasislegierung, gebildet ist. Es hat sich gezeigt, dass insbesondere wenn das Material mit bzw. aus einer Magnesiumbasislegierung gebildet ist, ein Auftreten von Lunkern und/oder Poren bzw. Porenverzweigungen im Gussstück effizient vermeidbar ist.

Weitere Merkmale, Vorteile und Wirkungen ergeben sich aus den nachfolgend dargestellten Ausführungsbeispielen. In den Zeichnungen, auf welche dabei Bezug genommen wird, zeigen:
Fig. 1 eine schematische Darstellung eines Querschnittes einer erfindungsgemäßen Vorrichtung;
Fig. 2 eine schematische Darstellung eines Querschnittes einer weiteren erfindungsgemäßen Vorrichtung;
Fig. 3 eine schematische Darstellung eines Teilstückes der erfindungsgemäßen Vorrichtung der Fig. 2.

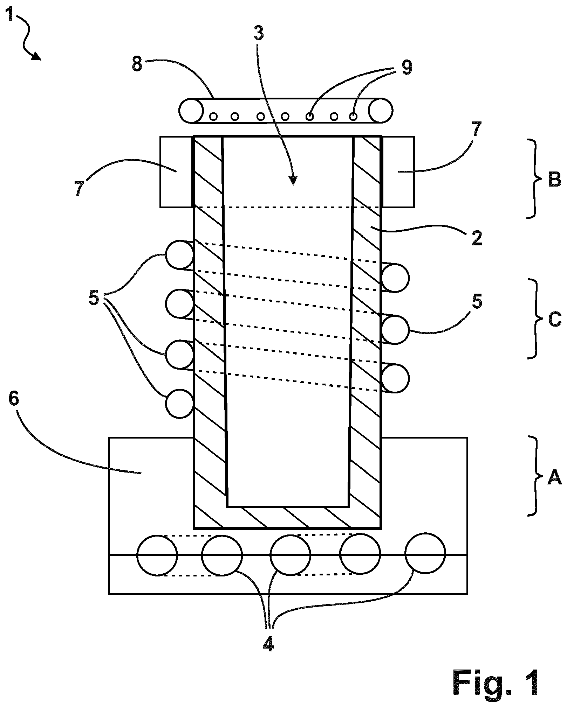

Fig. 1 zeigt eine schematische Darstellung eines Querschnittes einer Ausführungsvariante einer vorstehend beschriebenen Vorrichtung 1 zur Herstellung eines Gussstückes, insbesondere als Vormaterial. Die Vorrichtung 1 ist in einem Einsatzzustand dargestellt, in welchem die Vorrichtung 1 bzw. eine Temperierungsanlage der Vorrichtung 1 mit einem Tiegel 2 gekoppelt ist, um im Tiegel 2 bzw. in einer Kavität 3 des Tiegels 2 befindliches bzw. angeordnetes fließfähiges, insbesondere metallisches, Material, üblicherweise in Form einer Metallschmelze, zur Herstellung des Gussstückes durch Kühlung mit der Temperierungsanlage im Tiegel 2 erstarren zu lassen. Der Tiegel 2 bzw. eine gussteilformende Oberfläche der Kavität 3 des Tiegels 2 ist vorzugsweise mit bzw. aus Graphit gebildet. Der Tiegel 2 ist als offener Tiegel 2 ausgebildet und weist Seitenwände auf, welche in Richtung einer Befüllungsöffnung bzw. Gussstückentnahmeöffnung des Tiegels 2 divergierend zueinander ausgerichtet sind. Die Temperierungsanlage ist dabei derart ausgebildet und mit dem Tiegel 2 verbunden bzw. gekoppelt, dass mit dieser eine Temperaturdifferenz zwischen mehreren Regionen A, B, C des Tiegels 2, insbesondere zwischen einer ersten Region A des Tiegels 2 und zweiten Region B des Tiegels 2 sowie vorzugsweise einer dritten Region C des Tiegels 2, welche zwischen der ersten Region A und zweiten Region B angeordnet ist, einstellbar ist, um einen Temperaturgradienten im Material zu bewirken und dadurch eine gerichtete Erstarrung des Materials einzustellen bzw. diese zu steuern. Die in Fig. 1 gezeigte Temperierungsanlage weist einen unteren Temperierungsmittelkreislauf 4 auf, um eine erste Region A des Tiegels 2, welche insbesondere eine Bodenfläche des Tiegels 2 umfasst, zu kühlen. Am Tiegel 2 ist an einem oberen Ende des Tiegels 2 bzw. im Bereich der Befüllungsöffnung des Tiegels 2 an einer zweiten Region B des Tiegels 2 ein Isolierelement 7 vorhanden, welches insbesondere an einer Außenfläche des Tiegels 2 angeordnet ist, um eine Wärmeabfuhr von der zweiten Region B des Tiegels 2 an eine Umgebung zu hemmen. Auf diese Weise ist durch Kühlung der ersten Region A des Tiegels 2 mit dem unteren Temperierungsmittelkreislauf 4 eine Temperaturdifferenz zwischen der ersten Region A und zweiten Region B des Tiegels 2 einstellbar. Da mit dem Isolierelement 7 eine Wärmeabfuhr von der zweiten Region B des Tiegels 2 gehemmt wird, ist die Temperaturdifferenz zwischen der ersten Region A und zweiten Region B besonders genau einstellbar bzw. steuerbar. Aufgrund der Temperaturdifferenz ist ein Temperaturgradient im Material bewirkbar, sodass eine gerichtete Erstarrung des Materials einstellbar bzw. steuerbar ist, um auf diese Weise eine ausgeprägte definierte Gefügestruktur und/oder homogene Materialzusammensetzung des Gussstückes zu erreichen, wodurch das Gussstück mit hoher Qualität bzw. Güte herstellbar ist.

Weiter ist in Fig. 1 ersichtlich, dass die Temperierungsanlage einen oberen Temperierungsmittelkreislauf 5 aufweist, um eine dritte Region C des Tiegels 2, welche zwischen der ersten Region A und zweiten Region B am Tiegel 2 angeordnet ist, zu temperieren bzw. zu kühlen. Auf diese Weise können Temperaturdifferenzen zwischen der ersten Region A und dritten Region C sowie zwischen der dritten Region C und zweiten Region B eingestellt werden und damit über einen im Material erzeugten Temperaturgradienten eine gerichtete Erstarrung, insbesondere ausgehend von der ersten Region A über die dritte Region C in Richtung zweiter Region B, eingestellt bzw. gesteuert werden. In dieser Anordnung werden üblicherweise der untere Temperierungsmittelkreislauf 4 und der obere Temperierungsmittelkreislauf 5 als Kühleinrichtungen mit in der Regel unterschiedlichen Kühlraten betrieben.

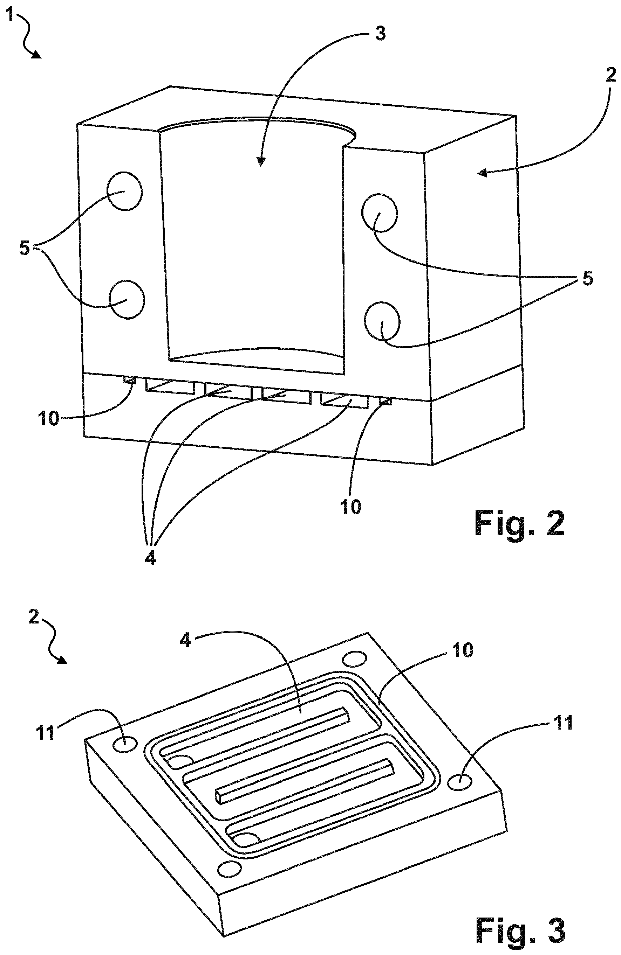

Der untere Temperierungsmittelkreislauf 4 weist ein Temperierungsmittelrohr zur Führung von Temperierungsmittel auf, welches zumindest abschnittsweise in einem Wärmeleitkörper angeordnet, welcher vorzugsweise als Kupferblock ausgebildet ist, um Wärme effizient zwischen Tiegel 2 bzw. Tiegelboden und unterem Temperierungsmittelkreislauf 4 bzw. dessen Temperierungsmittelrohr zu übertragen. Das Temperierungsmittelrohr des unteren Temperierungsmittelkreislaufes 4 bzw. ein Abschnitt dieses ist dabei mäanderförmig verlaufend innerhalb des Wärmeleitkörpers angeordnet. Der Wärmeleitkörper ist als Tiegeltopf 6 ausgebildet und weist eine zu einer Außengestalt des Tiegels 2 bzw. dessen unteren Endes korrespondierende Tiegelaufnahme auf, in welcher der Tiegel 2 bzw. dessen unteres Ende angeordnet ist. Ein im Wärmeleitkörper bzw. Tiegeltopf 6 angeordneter Abschnitt des Temperierungsmittelrohres ist vorzugsweise mit Ausnehmungen bzw. Bohrungen im Wärmeleitkörper ausgebildet, um durch diese Temperierungsmittel zu führen. Für eine einfache Herstellung des Wärmeleitkörpers bzw. Tiegeltopfes 6 ist es günstig, wenn dieser mehrteilig ausgebildet ist, wobei mehrere Teile des Wärmeleitkörpers bzw. Tiegeltopfes 6 vorzugsweise lösbar miteinander verbunden sind. Im Besonderen können dadurch eine oder mehrere Ausnehmungen bzw. Bohrungen, welche einen im Wärmeleitkörper bzw. Tiegeltopf 6 angeordneten Abschnitt eines Temperierungsmittelrohres bilden, besonders einfach in den Wärmeleitkörper bzw. Tiegeltopf 6, beispielsweise mittels Bohren oder Fräsen, eingebracht werden, ersichtlich beispielsweise auch in Fig. 3. Der obere Temperierungsmittelkreislauf 5 weist ein Temperierungsmittelrohr zur Führung von Temperierungsmittel auf, welches zumindest abschnittsweise schraubenartig geformt um den Tiegel 2 bzw. dessen Außenoberfläche bzw. Außenwand geführt ist.

Die in Fig. 1 gezeigte Vorrichtung 1 weist eine Schutzgaseinrichtung auf, welche mit einem Schutzgaszuführungsrohr 8 gebildet ist, wobei das Schutzgaszuführungsrohr 8 mehrere Austrittsöffnungen 9 aufweist, sodass über das Schutzgaszuführungsrohr 8 zugeführtes Schutzgas, vorzugsweise Argon, durch die Austrittsöffnungen 9 in Richtung Kavität 3 bzw. des darin angeordneten Materials geleitet wird. Auf diese Weise sind Oxidationsreaktionen zwischen dem Material und einer Umgebungsatmosphäre effizient reduzierbar.

Fig. 2 zeigt eine schematische Darstellung eines Querschnittes einer weiteren Ausführungsvariante einer Vorrichtung 1 zur Herstellung eines Gussstückes, insbesondere als Vormaterial. Grundsätzlich weist die Vorrichtung 1 der Fig. 2 einen zur Vorrichtung 1 der Fig. 1 analogen Aufbau auf und kann entsprechend mit denselben Merkmalen und dazu korrespondierenden Wirkungen ausgeführt sein, dies gilt analog auch in umgekehrter Weise. Im Unterschied zur Vorrichtung 1 der Fig. 1 sind der untere Temperierungsmittelkreislauf 4 bzw. dessen Temperierungsmittelrohr sowie der obere Temperierungsmittelkreislauf 5 bzw. dessen Temperierungsmittelrohr zumindest teilweise bzw. abschnittsweise in zumindest einer Tiegelwand des Tiegels 2 bzw. einen den Tiegel bildenden Tiegelkörper angeordnet bzw. geführt. Auf diese Weise ist ein sehr kompakter Aufbau erreichbar. Günstig ist es, wenn der Tiegel 2 mehrteilig ausgebildet ist, wobei mehrere Teile des Tiegels 2 vorzugsweise lösbar miteinander verbunden sind. Dadurch ist neben einer einfachen Wartbarkeit bzw. Reinigbarkeit, insbesondere ein einfaches Einbringen eines Temperierungsmittelrohres in die Tiegelwand, im Speziellen in Form einer oder mehrerer das Temperierungsmittelrohr bildenden in die Tiegelwand eingebrachten Ausnehmungen bzw. Bohrungen, ermöglicht. Dies ist gut ersichtlich in Fig. 3 dargestellt. Wie in Fig. 2 gezeigt, bildet ein Unterteil des Tiegels 2 einen vom Tiegel 2 lösbaren Teil des Tiegels 2, wobei in eine Oberfläche des Unterteiles Ausnehmungen eingebracht sind, mit welchen das Zuführungsrohr der unteren Temperierungseinrichtung 4 gebildet ist.

Fig. 3 zeigt das lösbare Unterteil des Tiegels 2 der Fig. 2 in einer anderen Ansicht. Gut ersichtlich ist eine in die Oberfläche des Unterteiles des Tiegels 2 eingebrachte mäanderförmig geformte Ausnehmung, welche zumindest einen Abschnitt des Temperierungsmittelrohres des unteren Temperierungsmittelkreises 4 bildet. Die Ausnehmung kann beispielsweise mittels Fräsen in die Oberfläche eingebracht sein. Weiter in Fig. 3 ersichtlich ist eine Dichtungseinrichtung, gebildet bevorzugt mit zumindest einer Dichtungselementführung 10 und zumindest einem in diese einfügbaren bzw. eingefügten Dichtungselement, um in einem Verbindungszustand des Tiegels 2, in welchem die mehreren Teile des Tiegels 2, bzw. der Unterteil mit einem Oberteil des Tiegels 2, verbunden sind, einen temperierungsmitteldichten, insbesondere flüssigkeitsdichten, Verbund zwischen den Teilen des Tiegels 2 zu gewährleisten. Günstig ist es, wenn der Tiegel 2 eine oder mehrere Verbindungseinrichtungen aufweist, um mehrere Teile des Tiegels 2 lösbar zu verbinden. Wie in Fig. 3 ersichtlich, weist der Unterteil Bohrlöcher 11 auf, durch welche Verbindungselemente, wie Schrauben oder Bolzen, durchführbar sind, um den Unterteil mit einem Oberteil des Tiegels 2 zu verbinden.

Eine erfindungsgemäße Vorrichtung 1 ermöglicht es damit, auf praktikable Weise eine Temperaturdifferenz zwischen verschiedenen Regionen A, B, C des Tiegels 2 einzustellen, um auf diese Weise einen Temperaturgradienten in einem im Tiegel 2 befindlichen Material zu bewirken und dadurch eine gerichtete Erstarrung im Material einzustellen bzw. zu steuern. Auf diese Weise ist im Besonderen ein Gussstück als Vormaterial mit einer definierten Gefügestruktur und homogenen Materialzusammensetzung erreichbar, sodass insbesondere Vormaterial von hoher Qualität bzw. Güte herstellbar ist.

## Patentansprüche

1. Vorrichtung (1) zur Herstellung eines, insbesondere metallischen, Gussstückes, bevorzugt als Vormaterial, umfassend eine Temperierungsanlage, wobei die Vorrichtung (1) einen Tiegel (2) aufweist oder mit einem Tiegel (2) koppelbar ist, um im Tiegel (2) befindliches fließfähiges, insbesondere metallisches, Material in einem Einsatzzustand der Vorrichtung (1) zur Herstellung des Gussstückes durch Kühlung mit der Temperierungsanlage im Tiegel (2) erstarren zu lassen, **dadurch gekennzeichnet, dass** mit der Temperierungsanlage eine Temperaturdifferenz zwischen einer ersten, insbesondere unteren, Region (A) und einer zweiten, insbesondere oberen, Region (B) des Tiegels (2) einstellbar ist, um zur gerichteten Erstarrung des Materials einen Temperaturgradienten im Material zu bewirken.

2. Vorrichtung (1) nach Anspruch 1, **dadurch gekennzeichnet, dass** die Vorrichtung (1) zumindest eine Temperaturmesseinrichtung aufweist, um im Einsatzzustand eine Tiegeltemperatur und/oder eine Temperatur eines im Tiegel (2) befindlichen Materials zu ermitteln, sodass die Temperierungsanlage in Abhängigkeit einer Ermittlungstemperatur der zumindest einen Temperaturmesseinrichtung steuerbar bzw. regelbar ist.

3. Vorrichtung (1) nach Anspruch 1 oder 2, **dadurch gekennzeichnet, dass** die Temperierungsanlage eine oder mehrere, insbesondere separat voneinander steuerbare, Temperierungseinrichtungen, wie Kühleinrichtungen und/oder Heizeinrichtungen, aufweist, um im Einsatzzustand Temperaturdifferenzen zwischen mehreren Regionen des Tiegels (2) zu erzeugen, um zur gerichteten Erstarrung des Materials Temperaturgradienten im Material zu bewirken.

4. Vorrichtung (1) nach Anspruch 3, **dadurch gekennzeichnet, dass** eine oder mehrere der Temperierungseinrichtungen mit zumindest einem Temperierungsmittelkreislauf (4, 5), aufweisend ein, insbesondere flüssiges oder gasförmiges, Temperierungsmittel, bevorzugt ein Kühlmittel, gebildet sind, um im Einsatzzustand eine Region des Tiegels (2) zu kühlen bzw. zu heizen.

5. Vorrichtung (1) nach einem der Ansprüche 1 bis 4, **dadurch gekennzeichnet, dass** die Temperierungsanlage eine erste Temperierungseinrichtung, welche bevorzugt als Kühleinrichtung ausgebildet ist, aufweist, um im Einsatzzustand die erste Region (A) des Tiegels (2) auf eine erste Temperatur zu temperieren, und eine zweite Temperierungseinrichtung, welche insbesondere als Kühleinrichtung oder Heizeinrichtung ausgebildet ist, aufweist, um im Einsatzzustand die zweite Region (B) des Tiegels (2) auf eine zweite Temperatur zu temperieren, welche höher ist als die erste Temperatur, um einen Temperaturgradienten im Material einzustellen.

6. Vorrichtung (1) nach Anspruch 5, **dadurch gekennzeichnet, dass** die Temperierungsanlage eine oder mehrere weitere Temperierungseinrichtungen aufweist, um im Einsatzzustand zumindest eine zwischen der ersten Region (A) und zweiten Region (B) des Tiegels (2) angeordnete dritte Region (C) des Tiegels (2) zu kühlen oder zu heizen, um einen Temperaturgradienten im Material einzustellen.

7. Vorrichtung (1) nach einem der Ansprüche 3 bis 6, **dadurch gekennzeichnet, dass** eine der Temperierungseinrichtungen ausgebildet ist, im Einsatzzustand einen Boden des Tiegels (2) zu temperieren, insbesondere zu kühlen, um einen Temperaturgradienten im Material einzustellen.

8. Vorrichtung (1) nach einem der Ansprüche 3 bis 7, **dadurch gekennzeichnet, dass** zumindest ein Wärmeleitkörper vorhanden ist, um im Einsatzzustand mit dem Wärmeleitkörper Wärme zwischen dem Tiegel (2) und einer oder mehreren Temperierungseinrichtungen zu übertragen.

9. Vorrichtung (1) nach einem der Ansprüche 1 bis 8, **dadurch gekennzeichnet**, die Vorrichtung (1) bzw. die Temperierungsanlage einen Tiegeltopf (6) aufweist, in welchem zumindest ein Teil des Tiegels (2), üblicherweise ein unteres Ende des Tiegels (2), im Einsatzzustand, insbesondere unter Bildung einer formschlüssigen Verbindung, angeordnet ist.

10. Vorrichtung (1) nach Anspruch 9, **dadurch gekennzeichnet, dass** die Vorrichtung (1) eine Schutzgaseinrichtung aufweist, um im Einsatzzustand den Tiegel (2) bzw. ein im Tiegel (2) befindliches Material mit Schutzgas, insbesondere Argon oder Helium, zu beaufschlagen.

11. Verfahren zur Herstellung eines, insbesondere metallischen, Gussstückes, bevorzugt als Vormaterial, im Besonderen mit einer Vorrichtung (1) nach einem der Ansprüche 1 bis 10, wobei ein Tiegel (2), in welchem sich fließfähiges, insbesondere metallisches, Material befindet, mit einer Temperierungsanlage gekoppelt ist oder wird, wobei das Material zur Herstellung des Gussstückes durch Kühlung mit der Temperierungsanlage im Tiegel (2) erstarren gelassen wird, **dadurch gekennzeichnet, dass** mit der Temperierungsanlage eine Temperaturdifferenz zwischen einer ersten, insbesondere unteren, Region (A) und einer zweiten, insbesondere oberen, Region (B), des Tiegels (2) eingestellt wird, um zur gerichteten Erstarrung des Materials einen Temperaturgradienten im Material zu bewirken.

12. Verfahren nach Anspruch 11, **dadurch gekennzeichnet, dass** die Temperierungsanlage eine oder mehrere, insbesondere separat voneinander steuerbare, Temperierungseinrichtungen, wie Kühleinrichtungen und/oder Heizeinrichtungen, aufweist, mit welchen im Einsatzzustand Temperaturdifferenzen zwischen mehreren Regionen des Tiegels (2) erzeugt werden, um zur gerichteten Erstarrung des Materials Temperaturgradienten im Material zu bewirken.
